# EUROPÄISCHE PATENTSCHRIFT

(11) **EP 3 149 219 B1**
(45) Veröffentlichungstag und Bekanntmachung des Hinweises auf die Patenterteilung: **08.05.2019**
(21) Anmeldenummer: 15725596.9
(22) Anmeldetag: 26.05.2015
(51) Int. Cl.: C23C 14/06, C23C 14/00, C23C 14/35, C23C 14/58, B21D 37/00, B21D 22/00, B21D 37/01

(54) **MO-SI-B SCHICHTEN UND VERFAHREN ZU DEREN HERSTELLUNG**
MO-SI-B LAYERS AND METHOD FOR THE PRODUCTION THEREOF
REVÊTEMENTS MO-SI-B ET PROCÉDÉS DE FABRICATION DESDITS REVÊTEMENTS

(30) Priorität: 26.05.2014 DE 102014007589; 17.09.2014 US 201462051475 P
(43) Veröffentlichungstag der Anmeldung: 05.04.2017
(73) Patentinhaber: Oerlikon Surface Solutions AG, Pfäffikon, 8808 Pfäffikon (CH)
(72) Erfinder: RACHBAUER, Richard, 6800 Feldkirch (AT); ARNDT, Mirjam, 7310 Bad Ragaz (CH); MAYRHOFER, Paul Heinz, 7311 Neckenmarkt (AT); POLCIK, Peter, 6600 Reutte (AT); VIEWEG, Annika, 8700 Leoben (AT); KALAS, Jiri, 8873 Amden (CH); RIEDL, Helmut, 3932 Kirchberg (Walde) (AT)
(86) Internationale Anmeldenummer: PCT/EP2015/061600
(87) Internationale Veröffentlichungsnummer: WO 2015/181176

(56) Entgegenhaltungen:
- WO-A1-2012/104048
- US-A1- 2004 219 295
- LANGE A ET AL: "Oxidation behavior of magnetron sputtered double layer coatings containing molybdenum, silicon and boron", INTERMETALLICS, ELSEVIER SCIENCE PUBLISHERS B.V, GB, Bd. 48, 1. Oktober 2013 (2013-10-01), Seiten 19-27, XP028668030, ISSN: 0966-9795, DOI: 10.1016/J.INTERMET.2013.09.007
- PEREPEZKO J H ET AL: "Environmental Resistance of Mo-Si-B Alloys and Coatings", OXIDATION OF METALS, SPRINGER NEW YORK LLC, US, Bd. 80, Nr. 3, 12. Februar 2013 (2013-02-12), Seiten 207-218, XP035363400, ISSN: 0030-770X, DOI: 10.1007/S11085-013-9373-3 [gefunden am 2013-02-12]
- TANG Z ET AL: "Characterization and oxidation behavior of silicide coating on multiphase Mo-Si-B alloy", INTERMETALLICS, ELSEVIER SCIENCE PUBLISHERS B.V, GB, Bd. 16, Nr. 9, 15. August 2008 (2008-08-15), Seiten 1125-1133, XP024524235, ISSN: 0966-9795, DOI: 10.1016/J.INTERMET.2008.06.014 [gefunden am 2008-08-15]

## Beschreibung

Die vorliegende Erfindung betrifft Mo-Si-B Schichten mit sehr guten Schichteigenschaften, insbesondere hinsichtlich mechanischer Eigenschaften, Oxidationsbeständigkeit und im Allgemeinen thermischer Stabilität bei hohen Temperaturen (sogar 900 °C und höher).

Aus dem Stand der Technik ist bekannt MoSiB Schichten mittels Sputtern herzustellen (siehe LANGE A ET AL: "Oxidation behavior of magnetron sputtered double layer coatings containing molybdenum, silicon and boron",INTERMETALLICS, ELSEVIER SCIENCE PUBLISHERS B.V, GB, Bd. 48, 1. Oktober 2013 (2013-10-01), Seiten 19-27).

Die vorliegenden Erfindung betrifft Umformwerkzeuge mit einer Mo_{1-x-y}SiₓB_{y} Schicht, wobei die Schicht die T2-Phase umfasst, und Verfahren zu deren Herstellung gemäß Anspruch 1.

Aufgrund der aussergewöhnlichen Eigenschaften der Mo-Si-B Schichten gemäss der vorliegenden Erfindung, sind diese Schichten insbesondere für die Beschichtung von Bauteilen und Werkzeugen geeignet, welche bei hohen Temperaturen angewendet werden.

Die Mo-Si-B Schichten gemäss der vorliegenden Erfindung können für Umformwerkzeuge zur Warmumformung gut geeignet sein, wie beispielsweise zum Hotstamping.

Gemäss einer bevorzugten Ausführungsform der vorliegenden Erfindung werden die Mo-Si-B Schichten auf Werkzeugoberflächen abgeschieden, welche während der Anwendung hohen Temperaturen unterzogen werden.

Die Mo-Si-B Schichten gemäss der vorliegenden Erfindung können erfindungsgemäss wie folgt hergestellt und/oder bereitgestellt werden:
1. Die Mo-Si-B Schichten können mittels PVD Sputtern von Mo-Si Composite-Targets und B Targets in einer reaktiven Stickstoff-enthaltenen Atmosphäre dergestalt abgeschieden werden, dass die Mo-Si-B Schichten keine ternäre Mo_{1-x-y}SiₓB_{y}-basierte Phase umfassen, anschliessend werden die mit den Mo-Si-B Schichten beschichteten Werkzeugen bei hohen Temperaturen eingesetzt, wobei sich zumindest eine ternäre Mo_{1-x-y}SiₓB_{y}-basierte T2-Phase in den Mo-Si-B Schichten bildet, oder
2. Die Mo-Si-B Schichten können in einer ähnlichen Weise wie oben unter dem Punkt 1 beschrieben auf die Werkzeugoberflächen abgeschieden werden, aber bevor die Werkzeuge eingesetzt werden, werden zumindest die mit Mo-Si-B Schichten beschichteten Oberflächen einer Wärmebehandlung ausgesetzt (z.B. einer Wärmebehandlung in einer Vakuumatmosphäre), um zumindest eine ternäre Mo_{1-x-y}SiₓB_{y}-basierte T2-Phase in den Mo-Si.B Schichten zu bilden bevor die mit Mo-Si-B Schichten beschichteten Werkzeugen bei hohen Temperaturen eingesetzt werden

Refraktär Metalle, wie Mo, Ta oder W besitzen die höchsten Schmelzpunkte unter allen reinen Elementen und sind daher vor allem für Hochtemperaturanwendungen sehr interessant.

Für solche Anwendungen sind sowohl die Eigenschaften des Grundmaterials bei hohen Temperaturen, als auch eine thermisch stabile Schutzschicht wichtig. Eines dieser Systeme, welches immer mehr Beachtung im Bereich der Hochtemperaturforschung findet, sind Molybdän-Legierungen. Obwohl Molybdän einen sehr hohen Schmelzpunkt aufweist (Tₘ = 2623°C) ist die schlechte Oxidationsbeständigkeit bei Temperaturen über 400°C einsatzbegrenzend. Hohe Temperaturen führen zum Verdampfen des Oxides (MoO₃) und einem drastischen Massenverlust. Zulegieren von Silizium erhöht die Temperaturbeständigkeit von Molybdän bei hohen Temperaturen, da es dadurch zur Bildung einer schützenden SiO₂ Schicht kommt. Um die Legierung auch bei niedrigen Temperaturen zu schützen, wird Bor zulegiert, welches unter oxidativer Atmosphäre eine glasähnliche B₂O₃ Schicht bildet.

Die Oxidationsbeständigkeit wird extrem von den Phasen beeinflusst, die vorher im System eingestellt wurden. Die bedeutendsten Phasen im Dreiphasensystems Mo_{1-x-y}-Siₓ-B_{y}, sind die binaren Phasen Mo₃Si (A15, cP8, Cr₃Si-Prototyp), Mo₅Si₃ (D8m, tI32, W₅Si₃-Prototyp), MoSi₂(C11, tI6, MoSi₂-Prototyp) und die sogenannte T2 Phase (Mo₅SiB₂ (T2, I4/mcm, Cr₅B₃-Prototyp)). Der Mengenanteil der T2 Phase beeinflusst stark die Oxidationsbeständigkeit, diese muss aber durch zusätzliche vorangehende Behandlung, wie z.B. Vakuumglühen, eingestellt werden muss.

In dieser Arbeit wurden Schichten mit verschiedenen chemischen Zusammensetzungen Mo_{1-x-y}SiₓB_{y} durch PVD Magnetron Sputtern hergestellt und auf ihre strukturellen und mechanischen Eigenschaften untersucht. Durch sowohl drei elementare Targets als auch ein Mo-Si Composite-Target und ein elementares Bor-Target konnten verschiedene Zusammensetzungen eingestellt werden. Direkt nach der Beschichtung konnte bei keiner Zusammensetzung eine T2 Phase detektiert werden, lediglich die oben erwähnten binaren Phasen (hauptsächlich Mo₅Si₃ (D8m) und Mo₃Si (Al15)) lagen vor. Mit zunehmendem BorGehalt stellte sich vor allem auch eine XRD amorpher Struktur ein. Die Harte der hergestellten Schichten zeigte einen Anstieg auf ca. 20 GPa, bei mehr als 5 at% Silizium und Bor, mit zunehmendem Legierungsanteil. Durch eine Wärmebehandlung der Schichten in Vakuum bei 900°C, 1100°C und 1300°C wurde deren thermische Stabilität und Phasenentwicklung untersucht. Bereits ab 900°C kam es zu einem Auftreten der gewünschten T2 Phase und bei den XRD amorphen Schichten zur Kristallisation. In weiterer Folge kam es zu keiner weiteren Veränderung der Strukturen. Die Harte der Schichten zeigte durch die Wärmebehandlung einen weiteren Anstieg für alle B/Si Verhältnisse. Dabei zeigt vor allem die Mo_{0.53}Si_{0.37}B_{0.10} Schicht eine maximale Härte von 26 GPa, aufgrund der Bildung der T2-Phase. Oxidationsversuche für eine Stunde bei 900, 1100 und 1300 °C zeigten eine ausgezeichnete Oxidationsbeständigkeit der Schichten über einem weiten Zusammensetzungsbereich mit unterschiedlichen B/Si Verhältnissen.

XRD Analysen zeigen, dass sich vor allem bei den beständigsten Schichten die T2 Phase auch während der Oxidationsversuche bei hohen Temperaturen bildet. Mittels EDX Linienscans wurden die jeweilige verbleibenden Schichtdicken bestimmt und die Schicht mit dem höchsten B/Si Verhältnis (Mo0.58Si 0.28B0.14) stellte sich als die Schicht mit den besten Eigenschaften heraus. Diese chemische Zusammensetzung wies kaum Verlust an Schichtdicke durch die Oxidation auf, als auch eine T2 Struktur nach dem Oxidieren.

In dieser Studie konnten die bereits bestehenden Theorien über den Einfluss des B/Si Verhältnis auf die Oxidationsbeständigkeit experimentell bestätigt werden. Es konnte aber auch vielmehr gezeigt werden, dass in dünnen Schichten eine vorangehende Wärmebehandlung nicht notwendig ist, um eine T2 Phase einzustellen. Diese bildet sich bei einer Oxidationsbehandlung ausreichend schnell, um eine schützende Oxidschicht zu ermöglichen.

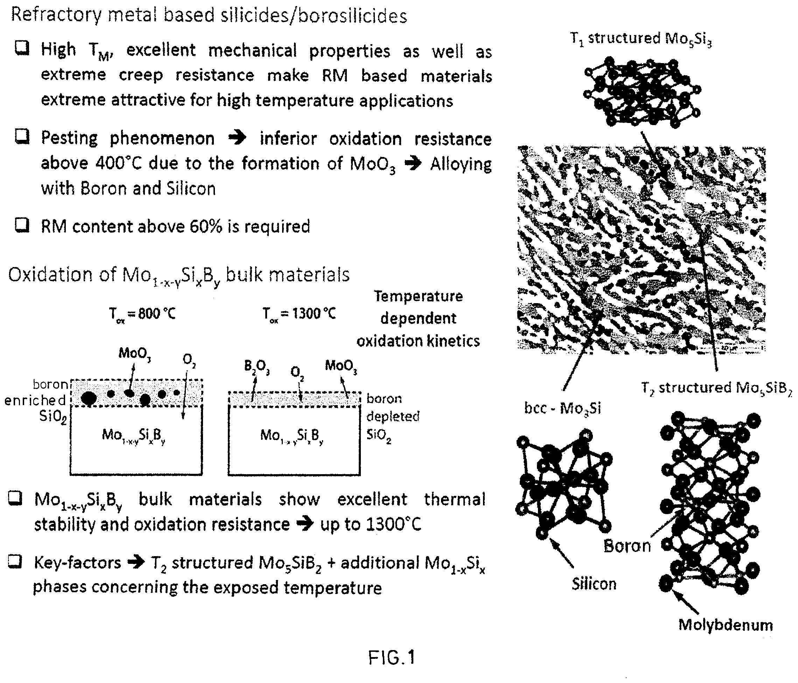

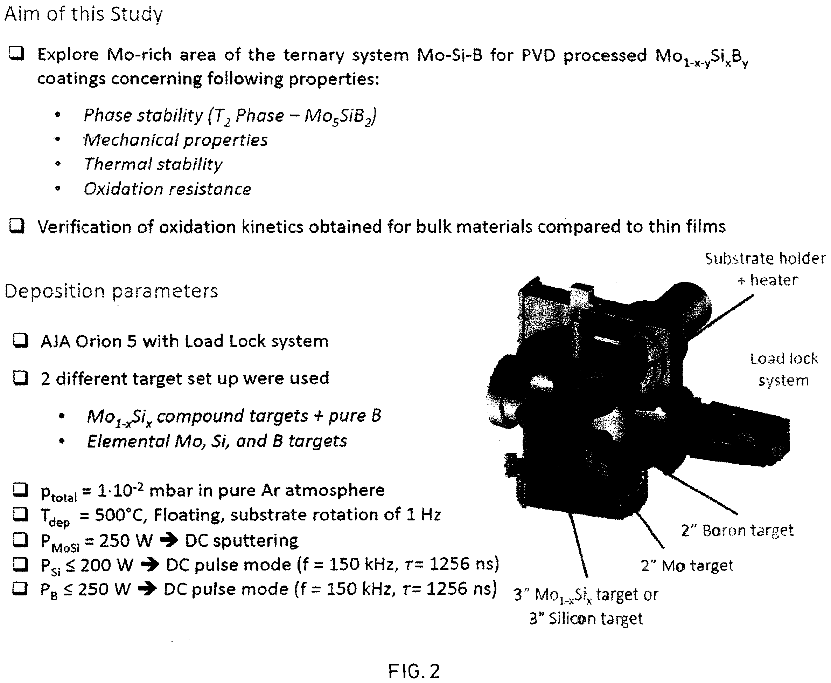

Folgend werden in den Figuren 1 bis 10 einige Experimente und Analyse dargestellt, welche helfen sollen die Erfindung besser zu verstehen.
Figur 1 zeigt den Oxidationsmechanismus Mo_{1-x-y}-Siₓ-B_{y} (Grundmaterial).
Figur 2 zeigt einer Beschichtungsanordnung zur Herstellung von Mo-Si-B Schichten gemäss der vorliegenden Erfindung gemäss einem ersten Beispiel:
   Die Mo_{1-x-y}-Siₓ-B_{y} Schichten wurden bei folgenden Beschichtungsparametern hergestellt:
   - Beschichtungsdruck p_{TOTAL} = 1 . 10 ⁻² mbar in einer im Wesentlichen reinen ArgonAtmosphäre
   - Beschichtungstemperatur T_{dep} = 500°C
   - Sputterleistung am Mo-Si Target P_{MoSi} = 250 W ← DC Sputtern
   - Sputterleistung am Si Target P_{Si} ≤ 200 W ← DC gepulst (f=150 kHz, τ=1256ns)
   - Sputterleistung am B Target P_{B} = 250 W ← DC gepulst (f=150 kHz, τ=1256ns)
   Ziel war die Untersuchung der Phasenstabilität, mechanischen Eingenschaften, thermischen Stabilität und Oxidationsbeständigkeit.

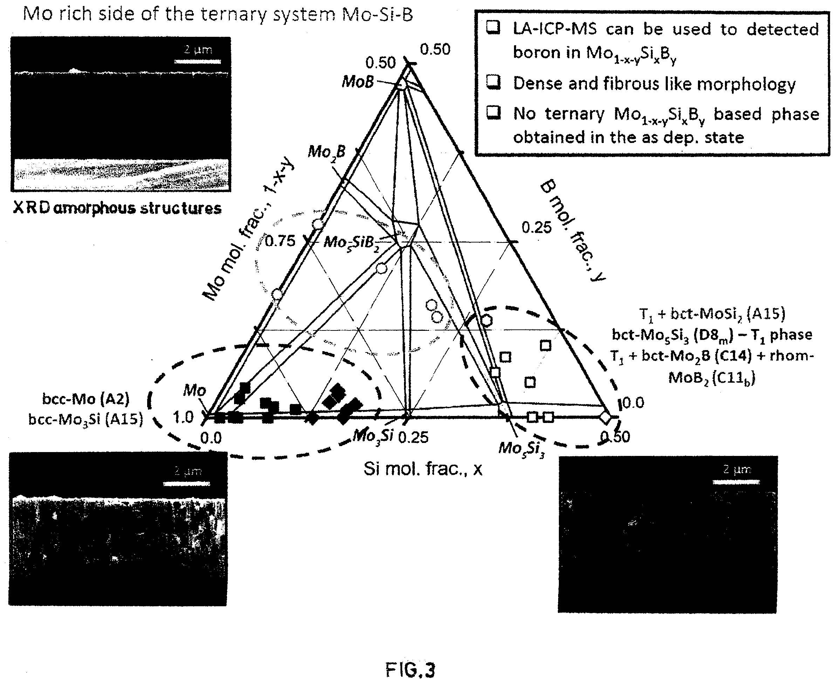

Figur 3 zeigt die Struktur und Morphologie der abgeschiedenen Mo_{1-x-y}-Siₓ-B_{y} Schichten.

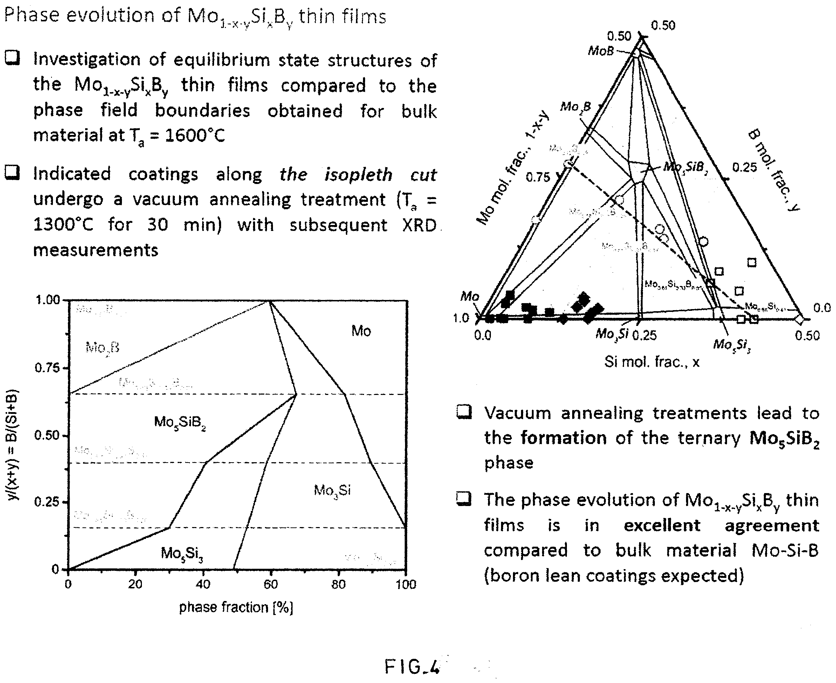

Figur 4 zeigt die Analyse der Phasenstabilität der abgeschiedenen Mo_{1-x-y}-Siₓ-B_{y} Schichten.

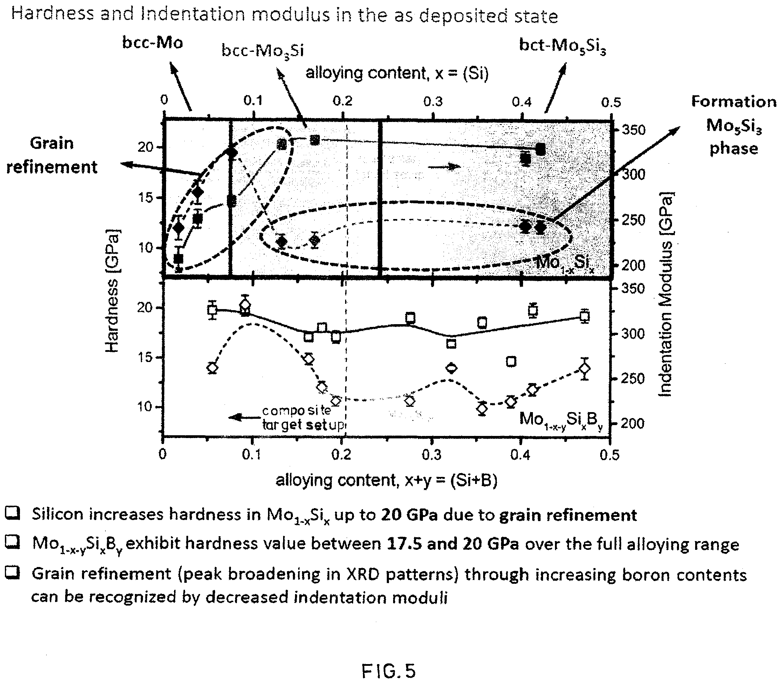

Figur 5 zeigt die Analyse der mechanischen Eigenschaften der abgeschiedenen Mo_{1-x-y}-Siₓ-B_{y} Schichten.

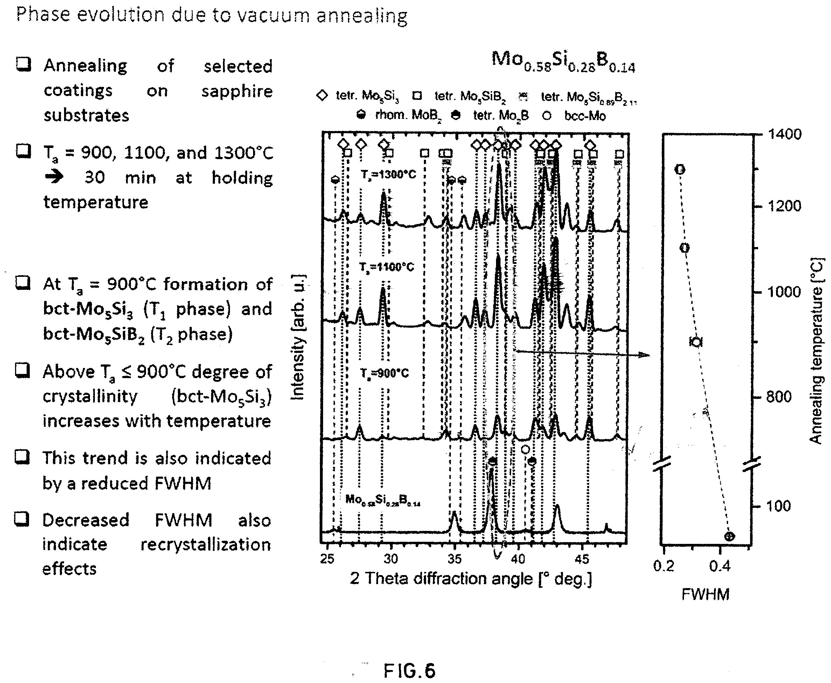

Figur 6 zeigt die Analyse der Phasenumwandlung der abgeschiedenen Mo_{1-x-y}-Siₓ-B_{y} Schichten, insbesondere am Beispiel vom Mo_{0.58}-Si_{0.28}-B_{0.14}, während Wärmebehandlungen in einer Vakuumatmosphäre.

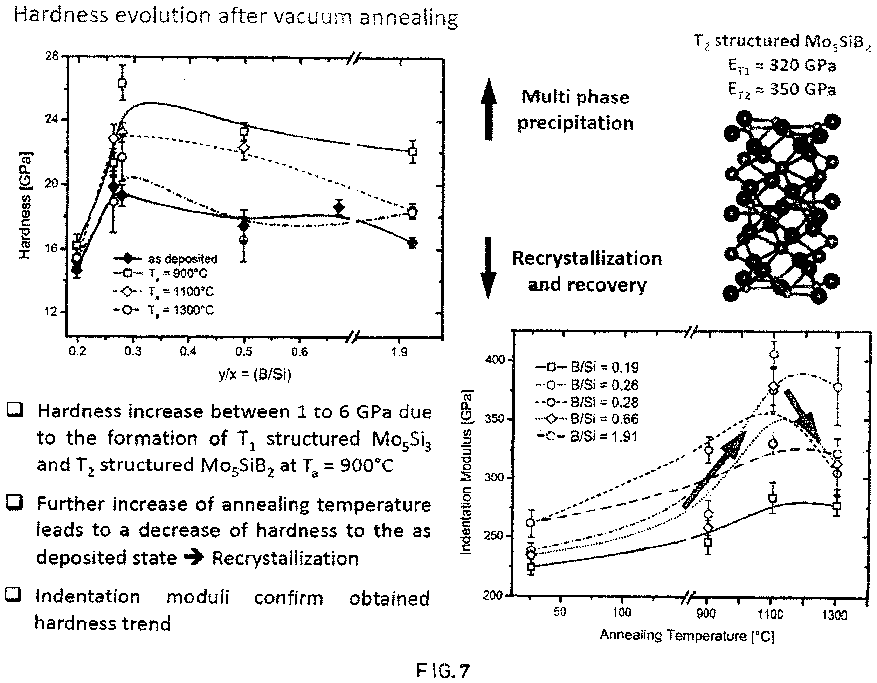

Figur 7 zeigt die Analyse der Stabilität der mechanischen Eigenschaften der abgeschiedenen Mo_{1-x-y}-Siₓ-B_{y} Schichten nach den Wärmebehandlungen.

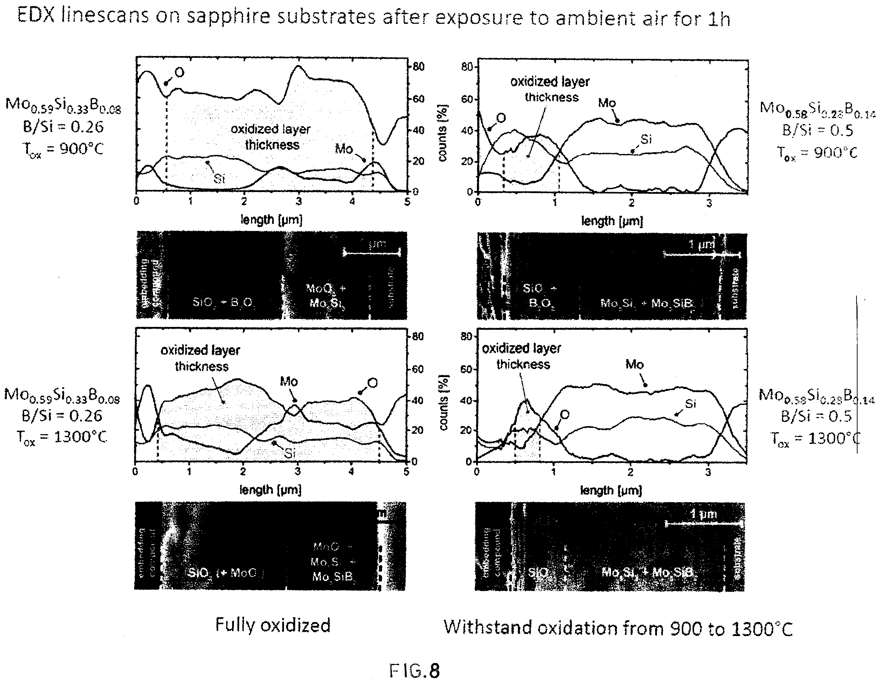

Figur 8 zeigt die Analyse der Oxidationsbeständigkeit der abgeschiedenen Mo_{1-x-y}-Siₓ-B_{y} Schichten.

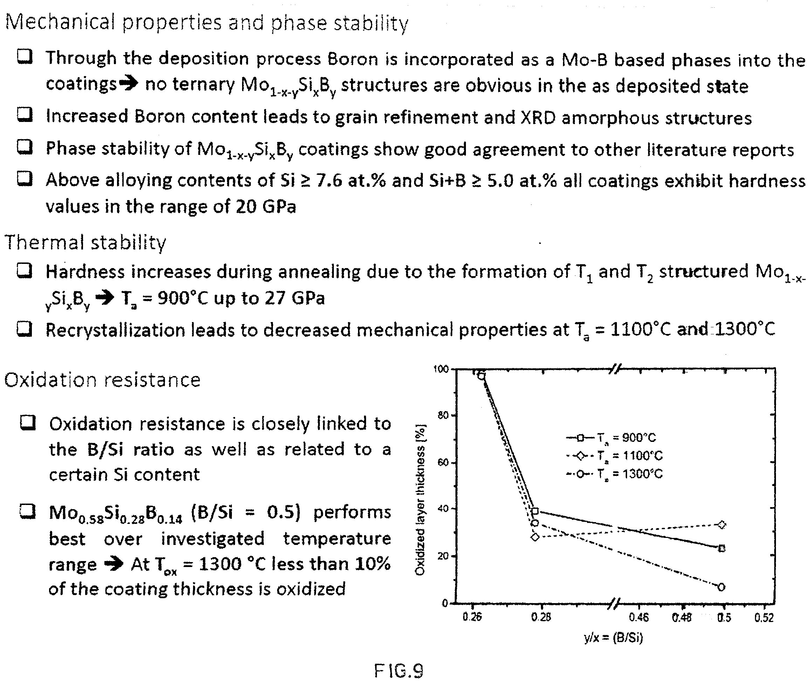

Figur 9 zeigt eine Zusammenfassung der analysierten Schichteigenschaften der abgeschiedenen Mo_{1-x-y}-Siₓ-B_{y} Schichten.

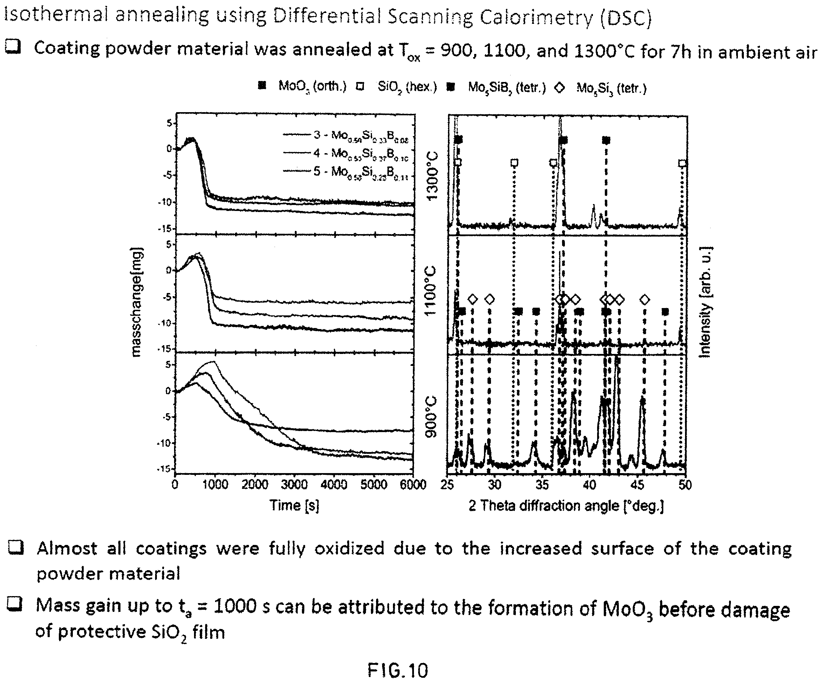

Figur 10 zeigt die Analyse der Oxidationsbeständigkeit der abgeschiedenen Mo_{1-x-y}-Siₓ-B_{y} Schichten, wenn sie zuerst pulverisiert werden und erst danach als Pulver untersucht werden.

| **Oerlikon Reference** | **EP Anmeldungsnr.** |
|---|---|
| PR 1403.0-PCT-EP | 15725596.9 |

| **Anmelder** | **Datum** |
|---|---|
| Oerlikon Surface Solutions AG, Pfäffikon | 2017-07-12 |

## Patentansprüche

1. Verfahren zur Herstellung einer Mo_{1-x-y}SiₓB_{y} Schicht durch Magnetron Sputtern unter zu Hilfenahme eines Mo-Si Composite Targets und eines elementaren B Targets, **dadurch gekennzeichnet, dass** die Schichten nach der Abscheidung, auf eine Temperatur von mindestens 900°C erhitzt werden wodurch sich eine T2- Phase bildet.

2. Umformwerkzeug mit einer Mo_{1-x-y}SiₓB_{y} Schicht, welche die T2-Phase aufweist.

## Claims

1. A process for producing a Mo_{1-x-y}SiₓB_{y} layer by magnetron sputtering by making use of a Mo-Si composite target and a target of elemental B, **characterized in that** the layers are heated to a temperature of at least 900°C after deposition, thereby forming a T2 phase.

2. A forming die comprising a Mo_{1-x-y}SiₓB_{y} layer comprising the T2 phase.

## Revendications

1. Procédé de fabrication d'un revêtement Mo_{1-x-y}SiₓB_{y} par pulvérisation magnétron à l'aide de l'utilisation d'une cible composite Mo-Si et d'une cible en B élémentaire, **caractérisée en ce que** les revêtements sont chauffés à une température d'au moins 900°C après dépôt, formant ainsi une phase T2.

2. Outil de formage comprenant un revêtement Mo_{1-x-y}SiₓB_{y} comprenant la phase T2.
